# EUROPÄISCHE PATENTSCHRIFT

(11) **EP 3 335 311 B1**
(45) Veröffentlichungstag und Bekanntmachung des Hinweises auf die Patenterteilung: **24.11.2021**
(21) Anmeldenummer: 16756962.3
(22) Anmeldetag: 08.08.2016
(51) Int. Cl.: H03B 29/00, G06F 1/025

(54) **RAUSCHGENERATOR**
NOISE GENERATOR
GÉNÉRATEUR DE BRUIT

(30) Priorität: 10.08.2015 DE 102015215222
(43) Veröffentlichungstag der Anmeldung: 20.06.2018
(73) Patentinhaber: Innovationszentrum für Telekommunikationstechnik GmbH IZT, 91058 Erlangen (DE)
(72) Erfinder: PERTHOLD, Rainer, 91085 Weisendorf (DE)
(74) Vertreter: Pfitzner, Hannes
(86) Internationale Anmeldenummer: PCT/EP2016/068872
(87) Internationale Veröffentlichungsnummer: WO 2017/025503

(56) Entgegenhaltungen:
- JP-A- 2001 185 998
- US-A- 5 153 532
- US-A1- 2006 186 930
- US-B1- 6 831 955

## Beschreibung

Ausführungsbeispiele der vorliegenden Erfindung beziehen sich auf einen Rauschgenerator zur Erzeugung eines Rauschsignals sowie auf ein entsprechendes Verfahren.

Rauschgeneratoren finden beispielsweise Anwendung in Kanalsimulatoren, die die Ausbreitungseffekte sowie die Beeinträchtigung von Signalen durch analoge Verarbeitungsstufen nachbilden.

Einer dieser nachzubildenden Störeinflüsse ist z.B. das sogenannte "Phasenrauschen" von Oszillatoren. Die Simulation für Phasenrauschen geschieht üblicherweise durch Erzeugung eines gemäß den Vorgaben des Anwenders gefärbten Rauschens. Dies gewinnt man üblicherweise aus weißem Rauschen, das dann entsprechend Anwendervorgaben gefiltert wird. Das Ergebnis dieses so erzeugten Rauschens kann entweder direkt als Rauschsignal genutzt und in ein Phasensignal überführt werden oder (bevorzugt) zwischengespeichert werden. Das zwischengespeicherte Ergebnis wird beispielsweise in einen Arbiträrgenerator geladen, zyklisch abgespielt und auf einen Phasenmodulator gegeben, der wiederum das Nutzsignal moduliert.

Die technische Herausforderung liegt hierbei darin, dass das reale Phasenrauschspektrum über einen weiten Frequenzbereich, wie z.B. von 1 Hz bis 10 MHz, mit erforderlicher Dynamik, z.B. von 100dB oder mehr exakt nachzubilden. Weiterhin soll das Signal eine möglichst lange Periode haben, bevor es sich wiederholt.

Zur Erzeugung von Signalen entsprechend derartigen Anforderungen gibt es unterschiedliche Möglichkeiten, die nachfolgend erläutert werden. Das gefärbte Rauschen wird gegebenenfalls auf einem separaten Rechner über geeignet bestimmte IIR- oder FIR-Filter erzeugt. Bei der Verwendung von IIR-Filtern ist von Nachteil, dass die Schätzverfahren, um die Filterkoeffizienten an den geforderten Frequenzgang anzupassen, angesichts der hohen Dynamik eine hohe Filterordnung benötigen und numerisch instabil werden können. Eine Kontrolle des Ergebnisses durch einen erfahrenen Anwender ist daher erforderlich. Für eine Anwendung in einem Messgerät ist dieses jedoch nicht akzeptabel.

Im Stand der Technik ist ein Rauschgenerator unter der JP-2001185998 erwähnt.

In der US 2006/186930 wird ein direkter digitaler Frequenzsynthesizer erläutert. Die US 5153532 beschreibt einen Rauschgenerator mit pseudozufälligen Sequenzgeneratoren. Ein weiterer Rauschgenerator ist in der US 6,831,955 gezeigt. Dieser umfasst zwei Rauschquellen.

Verwendet man FIR-Filter, so lassen sich dessen Koeffizienten auf einfache Weise zuverlässig schätzen. Allerdings ist die Anzahl der benötigten Koeffizienten sehr groß (z.B. 2^24). Somit wird viel Rechenzeit und Speicher bei der Bestimmung der Koeffizienten und nachfolgenden Filterung des weißen Rauschens benötigt. Eine interaktive Bedienung durch den Benutzer sowie die Implementierung direkt in einem Messgerät sind daher derzeit kaum zu realisieren.

Unabhängig vom verwendeten Filtertyp besteht das Problem, dass der weite Frequenzbereich Arbiträrgeneratoren mit relative hoher Abtastrate (z.B. 20 MSamples/sec.) bei gleichzeitig großer Speichertiefe (z.B. 1000 Sekunden entsprechend 40 GByte) erfordert, um eine hinreichend realistische Simulation zu erreichen. Der Zeitaufwand für die Berechnung der Rauschsequenz und das Laden des Arbiträrgenerators bewegen sich damit im Bereich von Minuten und sind für den Anwender nicht akzeptabel.

Um die Wiederholrate des gefärbten Rauschens (scheinbar) zu verbessern, kann man zu einem Trick greifen. Anstatt eines einzigen Rauschsignals erzeugt man zwei Rauschsignale, deren Längen teilerfremd zueinander sind. Beide werden in getrennten Arbiträrgeneratoren abgespielt und addiert, bevor sie auf den Phasenmodulator gegeben werden. In dem Frequenzbereich, in dem sich die Signale beider Arbiträrgeneratoren überlappen, kommt es jedoch häufig zu Abweichungen vom gewünschten Frequenzgang. Auf diese Weise erreicht man scheinbar eine sehr viel längere Periode (z.B. 217 Tage). Sofern es sich nur um zwei Rauschsignale handelt, ist die Autokorrelationsfunktion des Summensignals jedoch schlecht und die kurzen Wiederholdauern der beiden Arbiträrgeneratoren werden sichtbar.

Aufgabe der vorliegenden Erfindung ist es somit, einen Rauschgenerator für ein breites Frequenzspektrum zu schaffen, der einen verbesserten Kompromiss aus Bedienkomfort, Ressourceneffizienz (Rechenzeit und Speicherbedarf) und Frequenzgangabweichung darstellt.

Die Aufgabe wird durch den Gegenstand der unabhängigen Patentansprüche gelöst.

Ausführungsbeispiele der vorliegenden Erfindung schaffen einen Rauschgenerator zur Erzeugung eines Rauschsignals über ein Frequenzspektrum. Der Rauschgenerator umfasst eine erste Rauschquelle und einen ersten digitalen Filter für ein erstes Frequenzband des Frequenzspektrums, eine zweite Rauschquelle und ein zweites digitales Filter für ein zweites Frequenzband des Frequenzspektrums und einen Interpolierer sowie einen Kombinierer. Das erste digitale Filter ist ausgebildet, um das Ausgangssignal der ersten Rauschquelle zu filtern, während das zweite digitale Filter ausgebildet ist, um das Ausgangssignal der zweiten Rauschquelle zu filtern. Das erste digitale Filter weist eine erste Abtastrate auf, während das zweite digitale Filter eine zweite Abtastrate aufweist, wobei ein Verhältnis zwischen der zweiten Abtastrate und der ersten Abtastrate im Hinblick auf ein Vorzeichen einem Verhältnis zwischen Mittenfrequenzen des zweiten Frequenzbands zu dem ersten Frequenzband entspricht. Hierbei haben die Filter jeweils am Übergang vordefinierte Filterflanken, wobei eine Flanke des zweiten digitalen (34) Filters, die eine untere Frequenzbandgrenze bestimmt, steiler ist als eine Flanke des ersten digitalen Filters (34), die eine obere Frequenzbandgrenze bestimmt. Der Interpolierer ist ausgebildet, um ein Ausgangssignal des ersten digitalen Filters in Bezug auf seine Abtastrate einer Abtastrate des zweiten digitalen Filters anzupassen, während der Kombinierer ausgebildet ist, das angepasste Ausgangssignal vom Interpolierer und das Ausgangssignal des zweiten digitalen Filters zu kombinieren.

Kern der Erfindung liegt darin, in einem Rauschgenerator den geforderten Frequenzgang des (Phasen-)Rauschens (nachfolgend Frequenzspektrum genannt) in einzelne Frequenzbänder, wie z.B. zwei oder mehrere Frequenzbänder, zu unterteilen. Hierbei werden die Abtastraten der digitalen Filter entlang der aufsteigenden Frequenzachse so gewählt, dass sie ansteigen, z.B. jeweils um einen Faktor 2. Somit kann erreicht werden, dass die relative Bandbreite der einzelnen Filter konstant bleibt, wobei der geforderte Frequenzgang sich ressourcensparend gut mittels kurzen Filtern, wie z.B. FIR-Filtern, nachbilden lässt. Bevor die zwei Bänder kombiniert bzw. aufsummiert werden, wird das Band mit der niedrigeren Abtastrate (also auch das Band mit dem niedrigeren Frequenzbereich, vgl. Mittenfrequenz des Bands) durch einen Interpolator der Abtastrate des zweiten Bandes angepasst bzw. auf die gleiche Abtastrate wie das zweite Band gebracht. Dieser Ansatz ermöglicht schon ab einer Unterteilung des gesamten Frequenzspektrums in zwei Bänder eine realistische Nachbildung des Phasenrauschens eines Oszillators. Um nun auch noch an dem Übergang der zwei Bänder einen guten Frequenzgang sicherzustellen, sind die Filterflanken (z.B. RCOS-Flanken) in Hinblick auf die Interpolation des niedrigeren Bandes optimiert. So ist die untere Flanke (untere Frequenzbandgrenze) des zweiten digitalen Filters für das obere Band, steiler, z.B. doppelt so steil (abhängig von o.g. Faktor) als eine obere Flanke (obere Frequenzbandgrenze) des ersten digitalen Filters für das untere Band. Durch eine derartige Wahl kann erreicht werden, dass es in dem Überlappungsbereich (nach der Interpolation) zu einer optimalen Ergänzung der Filterflanken der zwei Bänder zu dem gewünschten Frequenzgang kommt. Bevorzugt wird ein sogenannter Root-Raised-Cosine-Filter eingesetzt, der "smoothe" Filterkanten aufweist. Die Kombination dieser Filterkanten mit unkorrelierten Rauschquellen führt dazu, dass es im Überlappungsbereich zu keiner Abweichung von dem geforderten Frequenzgang kommt. Dieser Ansatz ist derart effizient, dass sie (entsprechend Ausführungsbeispielen) auch in einer programmierbaren Logik umsetzbar ist. Diese einfache und realistische Erzeugung von (gefärbtem) Rauschen zeichnet sich auch durch hohen Bedienkomfort aus, da die Erzeugung des Phasenrauschens ohne lange Berechnungszeit bzw. Ladezeit (z.B. gegenüber Arbiträrgeneratoren) und ausgehend von numerisch stabilen Operationen erfolgen kann. Weitere Vorteile liegen in der sehr langen Wiederholdauer und dem großen erreichbaren Frequenzbereich.

Entsprechend weiteren Ausführungsbeispielen kann, wie oben bereits angedeutet, der Rauschgenerator auch um ein drittes Frequenzband, d.h. also mit einer dritten Rauschquelle und ein drittes digitales Filter für das dritte Frequenzband des Frequenzspektrums erweitert werden. Hierbei ist das dritte digitale Filter ausgebildet, um das Ausgangssignal der dritten Rauschquelle zu filtern, wobei das dritte digitale Filter eine dritte Abtastrate aufweist und wobei ein Verhältnis zwischen der dritten Abtastrate gegenüber der zweiten Abtastrate im Hinblick auf ein Vorzeichen ein Verhältnis zwischen Mittenfrequenzen ist, das dem des dritten Frequenzbands zu dem zweiten Frequenzband entspricht. Der Rauschgenerator umfasst in diesem Ausführungsbeispiel einen weiteren Interpolierer sowie einen weiteren Kombinierer. Der weitere Interpolierer ist ausgebildet, um ein Ausgangssignal des Kombinierers in Bezug auf seine Abtastrate einer Abtastrate des dritten digitalen Filters anzupassen, und wobei der weitere Kombinierer ausgebildet ist, ein Ausgangssignal vom weiteren Interpolierer und das Ausgangssignal des dritten digitalen Filters zu kombinieren. Hierbei ist es entsprechend Ausführungsbeispielen vorteilhaft, wenn das Verhältnis zwischen der zweiten Abtastrate gegenüber der ersten Abtastrate dem Verhältnis zwischen der dritten Abtastrate gegenüber der zweiten Abtastrate gleich oder annähernd gleich bleibt. Entsprechend zusätzlichen Ausführungsbeispielen ist abhängig von diesem Verhältnis auch die Rate mittels welcher die Anpassung der Abtastraten, ausgeführt durch den Interpolierer, erfolgt. Entsprechend den bevorzugten Ausführungsbeispielen verdoppelt sich die Abtastrate (d.h. Verhältnis 2:1) vom ersten Band zum zweiten Band, bzw. vom zweiten Band zum dritten Band. Ausgehend hiervon kann dann auch eine Verdopplung der Abtastrate in dem jeweiligen Interpolierer erfolgen, so dass beim Kombinieren Ausgangssignale mit gleicher Abtastrate kombiniert werden. An dieser Stelle sei angemerkt, dass das Kombinieren beispielsweise ein Aufsummieren sein kann. Entsprechend weiteren Ausführungsbeispielen werden die Filterflanken der unterschiedlichen Bänder im Hinblick auf dieses Kombinieren optimiert. Hierzu erfolgt eine entsprechende Anpassung der Steilheit der Filterflanken. So umfasst zumindest der zweite digitale Filter eine Filtercharakteristik, entsprechend welcher die Flanken eine unterschiedliche Steilheit aufweisen. Hierbei kann beispielsweise die Flanke mit der niedrigeren Übertragungscharakteristik doppelt so steil sein wie die Flanke mit der höheren Übertragungscharakteristik. Dies gilt auch für die filterübergreifende Betrachtung. Demnach kann die Flanke mit der niedrigen Übertragungsfrequenz ebenfalls doppelt so steil sein wie eine Flanke mit einer höheren Übertragungsfrequenz des ersten digitalen Filters.

Entsprechend weiteren Ausführungsbeispielen kann der Rauschgenerator in zumindest einem Pfad, also für ein Frequenzband, Mittel zur Pegelanpassung umfassen. Ferner ist es auch entsprechend Ausführungsbeispielen denkbar, dass der Rauschgenerator ausgangsseitig mit einem Integrator kombiniert ist, mittels welchem die Ausgangssignale über die Zeit aufsummiert werden. Entsprechend weiteren Ausführungsbeispielen wäre es insbesondere in einer Kombination mit dem Integrator auch möglich, dass ausgangsseitig Mittel zur Modulation vorgesehen sind, mittels welchen das Ausgangssignal des Rauschgenerators von einer Frequenzmodulation in Phasenmodulation überführt wird.

Weiterbildungen sind anhand der Unteransprüche definiert. Ausführungsbeispiele werden nachfolgend anhand der beiliegenden Zeichnungen erläutert. Es zeigen:
- Fig. 1: ein schematisches Blockschaltbild eines Rauschgenerators gemäß einem ersten Ausführungsbeispiel der Erfindung;

- Fig. 2a: ein schematisches Blockschaltbild eines Rauschgenerators gemäß einem erweiterten Ausführungsbeispiel der Erfindung; und
- Fig. 2b: ein schematisches Diagramm einer Aufteilung des gewünschten Rauschspektrums in unterschiedliche Frequenzbänder (in logarithmischer Darstellung).

Bevor nachfolgend Ausführungsbeispiele der vorliegenden Erfindung anhand der Figuren im Detail erläutert werden, sei darauf hingewiesen, dass gleichwirkende Elemente und Strukturen mit gleichen Bezugszeichen versehen sind, so dass die Beschreibung derer aufeinander anwendbar bzw. austauschbar ist.

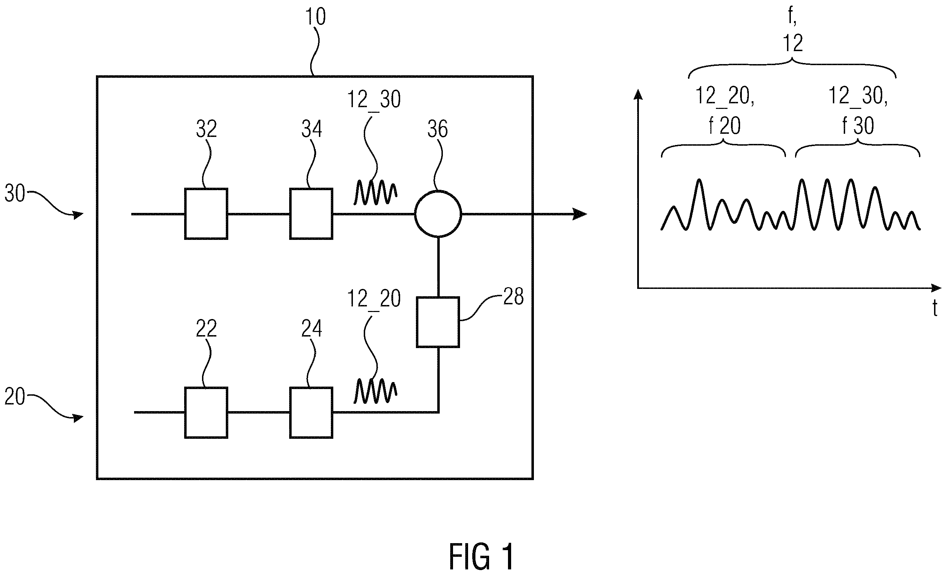

Fig. 1 zeigt einen Rauschgenerator 10 zur Erzeugung eines Rauschsignals 12 über ein Frequenzspektrum f (z.B. von 1 Hz bis 10 MHz oder bis 20 MHz). Der Rauschgenerator 10 umfasst zwei Rauschpfade 20 und 30.

Der erste Rauschpfad 20 umfasst eine erste Rauschquelle 22 und ein erstes digitales Filter 24 für ein erstes Frequenzband f 20 des Frequenzspektrums f (z.B. von 1 Hz bis 1 MHz oder 5 MHz). Die Rauschquelle 22 und das digitale Filter 24 sind derart in Serie angeordnet, dass das Ausgangssignal der Rauschquelle 22 durch das digitale Filter 24 filterbar ist. Der zweite Pfad 30 umfasst eine zweite Rauschquelle 32 sowie ein zweites digitales Filter 34 für ein zweites Frequenzband f 30 (z.B. von 1 MHz bis 10 MHz oder von 5 MHz bis 20 MHz). Analog zu dem ersten Pfad 20 sind Rauschquelle 32 und digitale Filter 34 ebenfalls in Serie angeordnet.

Die beiden Pfade 20 und 30 sind durch einen Kombinierer 36, der beispielsweise Teil des Pfades 30 ist, verbunden. Der Kombinierer 36 ist derart angeordnet, dass er ein Ausgangssignal des Pfades 20 mit einem Ausgangssignal des zweiten digitalen Filters 34 kombinieren kann. Aufseiten des Pfades 20 ist zwischen dem zweiten digitalen Filter 24 und dem Kombinierer 36 ein Interpolierer 28 vorgesehen. Der Kombinierer 36 stellt in diesem Ausführungsbeispiel den Ausgang des Rauschgenerators 10 dar.

Nachfolgend wird die Funktionsweise des Rauschgenerators erläutert. Die beiden Rauschquellen 22 und 32 sind dazu ausgebildet, ein Rauschen oder unkorreliertes Rauschen, wie z.B. ein weißes Rauschen oder adaptives weißes Gaußsches Rauschen AWGN (engl.: adaptive white Gausian Noise) zu erzeugen. Dieses Rauschen wird in einem nachfolgenden Schritt durch die Filter 24 und 34, bevorzugt digitale Filter, wie z.B. FIR-Filter oder RCC-Filter, gefiltert. Dadurch, dass jeder Pfad 20 bzw. 30 einem bestimmten Frequenzband f 20 bzw. f 30 mit einer im Vergleich zu dem gesamten Frequenzband f eingeschränkten Bandbreite (d.h. vergleichsweise kurze FIR-Filter) zugeordnet ist, können die Filter 24 und 34 schmalbandiger ausgeführt sein, so dass die Anzahl an benötigten Koeffizienten zur Generierung des gefärbten Rauschens wesentlich reduziert ist. Ein weiterer Trick bestünde darin, dass unterschiedliche Abtastraten für die zwei Filter 24 und 34 gewählt werden. Diese können sich beispielsweise um den Faktor 2 unterscheiden, so dass also der Filter 24 eine halb so große Abtastrate hat wie der Filter 34. Dadurch kann sichergestellt werden, dass die relative Bandbreite der einzelnen Filter 24 und 34 konstant bleibt. Im Ergebnis werden durch die zwei Filterbänke 24 und 34 jeweils unkorrelierte Rauschsignale 12-20 und 12-30 in unterschiedlichen Frequenzbändern f 20 und f30 ausgegeben, wobei die unterschiedlichen Ausgangssignale auch unterschiedliche Abtastraten haben.

Um diese zwei Rauschsignale 12-20 und 12-30 mittels des Kombinieres 36, z.B. einem Summierer, zu kombinieren, werden die unterschiedlichen Abtastraten ausgeglichen. Hierzu wird bevorzugt das Signal mit der niedrigeren Abtastrate des Pfades 20 an das Signal mit der höheren Abtastrate aus dem Pfad 30 angepasst. Dies erfolgt mittels einer Interpolation, ausgeführt durch den Interpolierer 28. Das so hinsichtlich Abtastrate angepasste Signal kann dann mittels des Kombinierers 36 aufsummiert werden, um dann das Rauschsignal 12 mit dem Frequenzspektrum f auszugeben.

Entsprechend Ausführungsbeispielen ist das Verhältnis zwischen der zweiten Abtastrate des zweiten Filters 34 gegenüber der ersten Abtastrate des ersten Filters 24 2,0. Ausgehend hiervon erfolgt durch den Interpolierer 28 eine Interpolation mit dem Faktor 2, so dass die Signale 12-20 und 12-30 beim Kombinierer 36 dieselbe Abtastrate aufweisen. Entsprechend weiteren Ausführungsbeispielen kann dieser Faktor auch anders gewählt sein und z.B. 4,0 oder auch 1,5 betragen. Das heißt also, dass die Verwendung des Interpolationsfaktors von 2,0 nicht zwingend ist, wobei es jedoch optimal in Bezug auf den Ressourcenaufwand erscheint, den Faktor 2,0 für Interpolation und Verhältnis zwischen den Abtastraten zu wählen, da andernfalls sowohl die Interpolationsfilter als auch die FIR-Filter eine größere Anzahl von Koeffizienten benötigen würden und gleichzeitig die Mehrfachausnutzung schwieriger würde. Allgemein sei darauf hingewiesen, dass die Abtastrate mit höherfrequentem Frequenzband zunimmt. Dieser Zusammenhang kann in anderen Worten auch dadurch dargestellt werden, dass das Verhältnis zwischen der zweiten Abtastrate gegenüber der ersten Abtastrate im Hinblick auf das Vorzeichen einem Verhältnis zwischen Mittenfrequenzen des zweiten Frequenzbands f 30 zu dem ersten Frequenzband f 20 entspricht.

Zusätzlich zu der Anpassung der beiden zu kombinierenden Rauschsignale 12-20 und 12-30 in Hinblick auf die unterschiedlichen Abtastraten erfolgt auch einen Anpassung der Filterflanken unter Berücksichtigung der Interpolation, durchgeführt durch den Interpolieren 28. Die Anpassung erfolgt bei den aneinander angrenzenden (RCOS-) Flanken, das heißt also bei der hochfrequenten Flanke des ersten Frequenzbands f 20 (Flanke zur Definition der oberen Frequenzbandgrenze für das untere Frequenzband) und bei der niedrigfrequenten Flanke des zweiten Frequenzbands f 30 (Flanke zur Definition der untere Frequenzbandgrenze im oberen Frequenzband). Ausgehend von dem Verhältnis der Abtastraten von 2,0 wäre die Wahl einer doppelt so steilen Flanke des unteren Frequenzbands f 20 im Vergleich zu der Flanke des oberen Frequenzbandes f 30 zu wählen. Allgemein kann also festgestellt werden, das ein Verhältnis zwischen der Steilheit der Flanke des zweiten digitalen (34) Filters und der Flanke des ersten digitalen (34) Filters in Abhängigkeit zu dem Verhältnis zwischen der zweiten Abtastrate gegenüber der ersten Abtastrate steht. Bei einer derartigen Wahl würden sich nach der Interpolation die so entstandenen Flanken derart ergänzen, dass der gewünschte Frequenzgang erreicht wird.

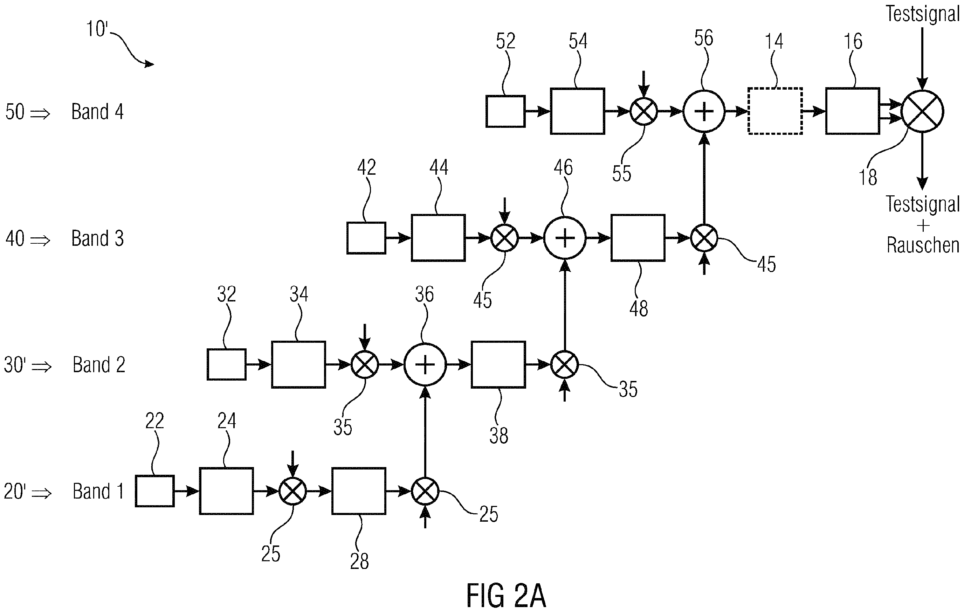

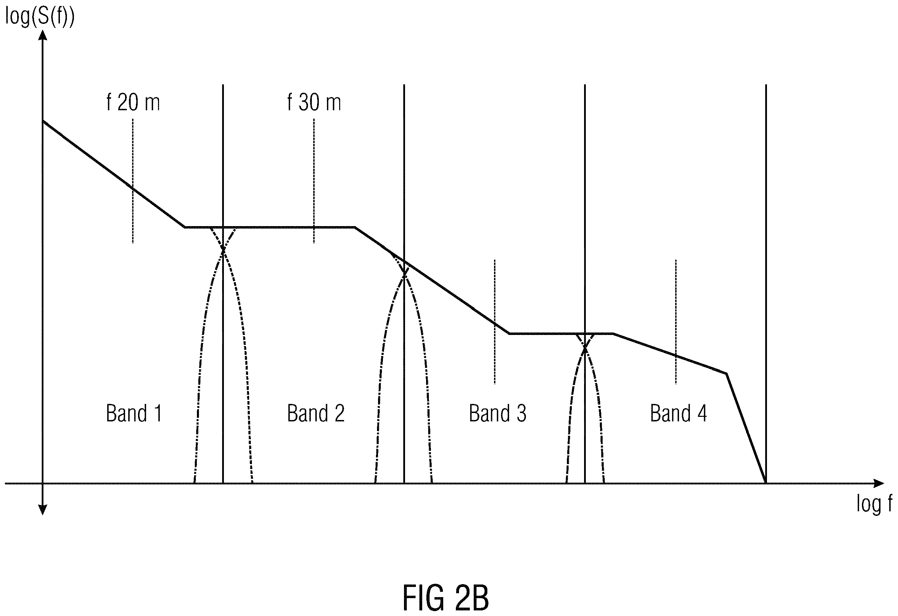

Fig. 2a zeigt ein erweitertes Ausführungsbeispiel eines Rauschgenerators 10' mit insgesamt vier Pfaden 20', 30', 40 und 50 für die Bänder 1, 2, 3 und 4, welche in Fig. 2b in logarithmischer Ansicht dargestellt sind.

Jeder Pfad 20', 30', 40 und 50 umfasst jeweils unabhängige Rauschquellen 22, 32, 42 und 52, digitale Filter 24, 34, 44 und 54 (hier Shaping Filter mit 31 Tabs FIR). Die Pfade 20', 30' und 40 umfassen zusätzlich noch den Interpolationsfilter 28, 38 und 48 (hier 2x Interpolationsfilter mit 31 Tabs FIR, während die Pfade 30', 40 und 50 jeweils den Kombinierer 36, 46 und 56 aufweisen. An dieser Stelle sei angemerkt, dass die Kombinierer 36 und 46 in den Pfaden 30' und 40 in Bezug auf den Interpolator 38 und 48 eingangsseitig vorgesehen sind. Hierdurch wird sichergestellt, dass immer die Abtastrate für das gesamte Summensignal in dem jeweiligen Pfad 30' bzw. 40' auf das nächsthöhere Niveau des Pfades 40 oder 50 angepasst wird.

Durch den Rauschgenerator 10' ergibt sich eine einfachere rekusive Struktur, die aus identischen Interpolationsfiltern 28, 38 und 48 und mit kurzen FIR-Filtern 24, 34, 44 und 54 mit zunehmender Abtastrate (mit zunehmender Mittenfrequenz der vier Teilbänder, Band 1-4) aufgebaut sind. Die Mittenfrequenzen sind exemplarisch in Fig. 2b mittels gestrichelten Linien dargestellt und mit den Bezugszeichen f 20m bzw. f 30m versehen. Diese Struktur lässt sich auch in einer programmierbaren Logik realisieren, wobei durch die Mehrfachnutzung der Logikressourcen sich beispielsweise auch 31 Stufen (Taps) effektiv realisieren lassen.

Die Funktionsweise des Rauschgenerators 10' entspricht grundsätzlich der Funktionsweise des Rauschgenerators 10, wobei hier eben der gesamte Frequenzbereich in insgesamt vier Bänder (vgl. Fig. 2b) aufgeteilt ist.

Entsprechend Ausführungsbeispielen können auch weitere Elemente in den Rauschgenerator 10' integriert sein. So kann entsprechend einem Ausführungsbeispiel zumindest einer, bevorzugt aber jeder der Pfade 20', 30', 40 und 50 Mittel zur Pegelanpassung 25 und 29, 35 und 39, 45 und 49 sowie 55 umfassen. Mittel 25, 35, 45 und 55 sind jeweils am Ausgang der Filter 24, 34, 44 und 54 vorgesehen, während die Mittel 29, 39 und 49 jeweils am Ausgang der Filter 28, 38 und 48 vorgesehen sind. Die Mittel zur Pegelanpassung können beispielsweise durch Multiplikatoren realisiert sein. Die Multiplikationsfaktoren werden typischerweise in Abhängigkeit von dem gewünschten Frequenzgang des Rauschsignals gewählt. Es sei an dieser Stelle angemerkt, dass es nicht zwingend notwendig ist, dass je Pfad 20', 30', 40 und 50 zwei Mittel zur Pegelanpassung 25/29, 35/39, 45/49 vorgesehen sein müssen, wobei dies jedoch das bevorzugte Ausführungsbeispiel darstellt. Durch die Anordnung der Pegelanpassungen 25, 29, 35, 39, 45, 49 und 55 zwischen den Filtern 24, 28, 34, 38, 44, 48 und 54 können Rundungsfehler durch die begrenzte Wortbreite der Berechnung minimiert werden.

Entsprechend weiteren Ausführungsbeispielen kann ausgangsseitig beim Rauschgenerator 10' ein Integrator 14 vorgesehen sein. Dieser ermöglicht für den Fall, dass der geforderte Frequenzgang des gefärbten Rauschens deutlich steiler als mit 20 dB/Dekade abfällt, dass die Anforderungen an die Wortbreite der Berechnung in den einzelnen Filtern reduziert werden können. In der gesamten Verarbeitungskette wird der Einfluss des Integrators 14 auf den Frequenzgang bei der Bestimmung der Shaping Filter entsprechend berücksichtigt.

Entsprechend weiteren Ausführungsbeispielen kann weiter ausgangsseitig des Rauschgenerators 10', z.B. nachgelagert in Bezug auf den optionalen Integrator 14, Mittel zur Modulation 16, z.B. eine Nachschlagtabelle bzw. eine Sinus/Cosinus-Nachschlagtabelle vorgesehen sein. Die Nachschlagtabelle 16 ist ausgebildet, um ausgehend von einem Summensignal (z.B. in der Form einer Frequenzmodulation) dieses in eine Phasenmodulation umzuwandeln. Dieses Phasenrauschen, ausgegeben durch den Modulator 16, kann mittels eines optionalen Mischers 18 auf ein Testsignal aufmoduliert werden. An dieser Stelle sei angemerkt, dass die für die Phasenmodulation eingesetzte Nachschlagtabelle typischerweise den kompletten Definitionsbereich von -pi bis +pi abdeckt, wobei es jedoch auch denkbar wäre, dass bei sehr schwach ausgesteuertem Phasenrauschen nur ein kleinerer Bereich genutzt wird. Insofern kann auch nur dieser kleinere Bereich geladen werden, um auf diese Weise Speicherplatz zu sparen oder die Auflösung zu erhöhen.

Auch wenn obige Ausführungsbeispiele bevorzugt im Zusammenhang mit einer Vorrichtung erläutert wurden, sei darauf hingewiesen, dass sich weitere Ausführungsbeispiele auf ein entsprechendes Verfahren beziehen. Das Verfahren umfasst die Schritte: Erzeugen eines Ausgangssignals mittels einer ersten Rauschquelle für ein erstes Frequenzband des Frequenzspektrums und Filtern des Ausgangssignals der ersten Rauschquelle; Erzeugen eines Ausgangssignals mittels einer zweiten Rauschquelle für ein zweites Frequenzband des Frequenzspektrums und Filtern des Ausgangssignals der zweiten Rauschquelle. Hierbei erfolgt die Filterung des Ausgangssignals der ersten Rauschquelle mittels einer ersten Abtastrate, während die Filterung des Ausgangssignals der zweiten Rauschquelle mittels einer zweiten Abtastrate erfolgt. Ein Verhältnis zwischen der zweiten Abtastrate gegenüber der ersten Abtastrate entspricht im Hinblick auf ein Vorzeichen einem Verhältnis zwischen Mittenfrequenzen des zweiten Frequenzbands zu dem ersten Frequenzband. In einem dritten Schritt erfolgt die Anpassung einer Abtastrate des gefilterten Ausgangssignals der ersten Rauschquelle an eine Abtastrate des gefilterten Ausgangssignals der zweiten Rauschquelle und das Kombinieren des angepassten Ausgangssignals der ersten Rauschquelle und des Ausgangssignals der zweiten Rauschquelle.

Die Implementierung dieses Verfahrens kann auch rechnerbasiert sein, wobei es hier vorteilhaft ist, dass dieses Verfahren im Vergleich zu weiteren Stand-der-Technik-Verfahren, wie z.B. des oben beschriebenen Verfahrens unter Nutzung eines FIR-Filters wesentlich weniger Rechenzeit und Speicher bei der Realisierung benötigen. Weiter sei darauf hingewiesen, dass entsprechend weiteren Ausführungsbeispielen das obige Verfahren insbesondere dazu geeignet ist, um auf einer programmierbaren Logik, wie z.B. einem FPGA implementiert zu werden. Da die Abtastrate der einzelnen Filter unterschiedlich ist, lässt sich eine ressourcensparende Verarbeitung der unterschiedlichen Bänder in unterschiedlichen Zeitschlitzen realisieren.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Rauschgenerator (10, 10') zur Erzeugung eines Rauschsignals über ein Frequenzspektrum (f), mit folgenden Merkmalen:
einer ersten Rauschquelle (22) und einem ersten digitalen Filter (24) für ein erstes Frequenzband (f 20) des Frequenzspektrums (f), wobei das erste digitale Filter (24) ausgebildet ist, das Ausgangssignal der ersten Rauschquelle (22) zu filtern;
einer zweiten Rauschquelle (32) und einem zweiten digitalen (34) Filter für ein zweites, höherfrequentes, Frequenzband (f 30) des Frequenzspektrums (f), wobei das zweite digitale Filter (34) ausgebildet ist, das Ausgangssignal der zweiten Rauschquelle (22) zu filtern; und
einem Interpolierer (28, 38, 48) sowie einem Kombinierer (36, 46, 56),
wobei das erste digitale (24) Filter eine erste Abtastrate aufweist und wobei das zweite digitale (34) Filter eine zweite Abtastrate aufweist, die größer als die erste Abtastrate ist,
wobei der Interpolierer (28, 38, 48) ausgebildet ist, um die Abtastrate eines Ausgangssignals des ersten digitalen (24) Filters einer Abtastrate des zweiten digitalen (34) Filters anzupassen, und wobei der Kombinierer (36, 46, 56) ausgebildet ist, um das angepasste Ausgangssignal vom Interpolierer (28, 38, 48) und das Ausgangssignal des zweiten digitalen Filters (34) zu kombinieren,
wobei eine Flanke des zweiten digitalen (34) Filters, die eine untere Frequenzbandgrenze bestimmt, steiler ist als eine Flanke des ersten digitalen Filters (24), die eine obere Frequenzbandgrenze bestimmt, wobei das Verhältnis zwischen besagter Steilheit der Flanke des zweiten digitalen Filters und besagter Flanke des ersten digitalen Filters in Abhängigkeit zu dem Verhältnis zwischen der zweiten Abtastrate gegenüber der ersten Abtastrate steht.

2. Rauschgenerator (10, 10') gemäß Anspruch 1, wobei die Flanke des zweiten digitalen (34) Filters doppelt so steil ist wie die Flanke des ersten digitalen Filters (24).

3. Rauschgenerator (10, 10') gemäß einem der vorherigen Ansprüche, wobei der Rauschgenerator (10, 10') eine dritte Rauschquelle (42, 52) und ein drittes digitales Filter (44, 54) für ein drittes Frequenzband des Frequenzspektrums (f) umfasst, wobei das dritte digitale Filter (44, 54) ausgebildet ist, das Ausgangssignal der dritten Rauschquelle (42, 52) zu filtern,
wobei das dritte digitale Filter (44, 54) eine dritte Abtastrate aufweist und wobei die Abtastrate mit höherfrequentem Frequenzband zunimmt, und
wobei der Rauschgenerator (10, 10') einen weiteren Interpolierer (28, 38, 48) sowie einen weiteren Kombinierer (36, 46, 56) umfasst, wobei der weitere Interpolierer (28, 38, 48) ausgebildet ist, um ein Ausgangssignal des Kombinierers (36, 46, 56) in Bezug auf seine Abtastrate einer Abtastrate des dritten digitalen Filters (44, 54) anzupassen, und wobei weitere Kombinierer (36, 46, 56) ausgebildet ist, ein Ausgangssignal vom weiteren Interpolierer (28, 38, 48) und das Ausgangssignal des dritten digitalen Filters (44, 54) zu kombinieren.

4. Rauschgenerator (10, 10') gemäß einem der vorherigen Ansprüche, wobei die erste und/oder zweite Rauschquelle (32) ausgebildet ist, ein weißes Rauschen zu erzeugen und als Ausgangssignal auszugeben.

5. Rauschgenerator (10, 10') gemäß einem der vorherigen Ansprüche, wobei das Verhältnis 2:1 ist.

6. Rauschgenerator (10, 10') gemäß einem der vorherigen Ansprüche, wobei der Interpolierer (28, 38, 48) ausgebildet ist, um das Ausgangssignal des ersten Filters (24) hinsichtlich seiner Abtastrate zu verdoppeln.

7. Rauschgenerator (10, 10') gemäß einem der vorherigen Ansprüche, wobei der Kombinierer (36, 46, 56) ein Summenglied umfasst.

8. Rauschgenerator (10, 10') gemäß einem der vorherigen Ansprüche, wobei das erste und/oder zweite digitale Filter (34) ein FIR-Filter und/oder ein RRC-Filter umfasst.

9. Rauschgenerator (10, 10') gemäß einem der Ansprüche 3 bis 8, wobei das zweite digitale (34) Filter eine Filtercharakteristik umfasst, entsprechend welcher die Flanken eine unterschiedliche Steilheit aufweisen.

10. Rauschgenerator (10, 10') gemäß Anspruch 9, wobei die Flanke mit der niedrigeren Übergangsfrequenz doppelt so steil ist wie die Flanke mit der höheren Übergangsfrequenz des zweiten digitalen Filters (34), und/oder
wobei die Flanke mit der niedrigeren Übergangsfrequenz doppelt so steil ist wie eine Flanke mit einer höheren Übergangsfrequenz des ersten digitalen Filters (24).

11. Rauschgenerator (10, 10') gemäß einem der vorherigen Ansprüche, wobei das erste (24) und/oder zweite digitale Filter (34) ausgangsseitig mit Mitteln zur Pegelanpassung (25, 29, 35, 39, 45, 49) gekoppelt ist.

12. Rauschgenerator (10, 10') gemäß einem der vorherigen Ansprüche, wobei der Rauschgenerator (10, 10') ausgangsseitig einen Integrator (14) umfasst, der ausgebildet ist, die kombinierten Ausgangssignale über die Zeit aufzusummieren.

13. Rauschgenerator (10, 10') gemäß einem der vorherigen Ansprüche, wobei der Rauschgenerator (10, 10')ausgangsseitig Mittel zur Modulation (16) umfasst, die ausgebildet sind, um das kombinierte Ausgangssignal von einer Frequenzmodulation in eine Phasenmodulation zu überführen.

14. Rauschgenerator (10, 10') gemäß Anspruch 13, wobei die Mittel zur Modulation (16) eine Nachschlagtabelle umfassen, die eine Zuordnung von Sinus-/Kosinus-Werten und Phasen-Werten über einen unbegrenzten oder begrenzten Wertbereich umfasst.

15. Verfahren zur Erzeugung eines Rauschsignals (12) über ein Frequenzspektrum (f), mit folgenden Schritten:
Erzeugen eines Ausgangssignals mittels einer ersten Rauschquelle (22) für ein erstes Frequenzband (f 20) des Frequenzspektrums (f) und Filtern des Ausgangssignals der ersten Rauschquelle (22);
Erzeugen eines Ausgangssignals mittels einer zweiten Rauschquelle (22) für ein zweites, höherfrequentes, Frequenzband (f 30) des Frequenzspektrums (f) und Filtern des Ausgangssignals der zweiten Rauschquelle (22), wobei die Filterung des Ausgangssignals der ersten Rauschquelle (22) mittels einer ersten Abtastrate erfolgt und die Filterung des Ausgangssignals der zweiten Rauschquelle (22) mittels einer zweiten Abtastrate erfolgt, die größer als die erste Abtastrate ist, und wobei eine Flanke des zweiten digitalen (34) Filters, die eine untere Frequenzbandgrenze bestimmt, steiler ist als eine Flanke des ersten digitalen Filters (24), die eine obere Frequenzbandgrenze bestimmt; und
Anpassen einer Abtastrate des gefilterten Ausgangssignals der ersten Rauschquelle (22) an eine Abtastrate des gefilterten Ausgangssignals der zweiten Rauschquelle (32) und Kombinieren des angepassten Ausgangssignals der ersten Rauschquelle (22) und des Ausgangssignals der zweiten Rauschquelle (22), wobei das Verhältnis zwischen besagter Steilheit der Flanke des zweiten digitalen Filters und besagter Flanke des ersten digitalen Filters in Abhängigkeit zu dem Verhältnis zwischen der zweiten Abtastrate gegenüber der ersten Abtastrate steht.

16. Computerprogramm mit einem Programmcode zur Durchführung des Verfahrens nach Anspruch 15, wenn das Programm auf einem Computer oder einem Logikbaustein abläuft.

## Claims

1. A noise generator (10, 10') for generating a noise signal over a frequency spectrum (f), comprising:
a first noise source (22) and a first digital filter (24) for a first frequency band (f 20) of the frequency spectrum (f), wherein the first digital filter (24) is configured to filter the output signal of the first noise source (22);
a second noise source (32) and a second digital filter (34) for a second higher frequency band (f 30) of the frequency spectrum (f), wherein the second digital filter (34) is configured to filter the output signal of the second noise source (22); and
an interpolator (28, 38, 48) and a combiner (36, 46, 56),
wherein the first digital filter (24) comprises a first sample rate, and wherein the second digital filter (34) comprises a second sample rate that is larger than the first sample rate,
wherein the interpolator (28, 38, 48) is configured to adjust the sample rate of an output signal of the first digital filter (24) to a sample rate of the second digital filter (34), and wherein the combiner (36, 46, 56) is configured to combine the adjusted output signal from the interpolator (28, 38, 48) and the output signal of the second digital filter (34),
wherein an edge of the second digital filter (34) which determines a lower frequency band limit is steeper than an edge of the first digital filter (24) which determines an upper frequency band limit, wherein the ratio between said steepness of the edge of the second digital filter and said edge of the first digital filter depends on the ratio between the second sample rate with respect to the first sample rate.

2. The noise generator (10, 10') in accordance with claim 1, wherein the edge of the second digital filter (34) is double as steep as the edge of the first digital filter (24).

3. The noise generator (10, 10') in accordance with any of the preceding claims, wherein the noise generator (10, 10') comprises a third noise source (42, 52) and a third digital filter (44, 54) for a third frequency band of the frequency spectrum (f), wherein the third digital filter (44, 54) is configured to filter the output signal of the third noise source (42, 52),
wherein the third digital filter (44, 54) comprises a third sample rate, and wherein the sample rate increases with an increasing frequency of the frequency band, and
wherein the noise generator (10, 10') comprises a further interpolator (28, 38, 48) and a further combiner (36, 46, 56), wherein the further interpolator (28, 38, 48) is configured to adjust an output signal of the combiner (36, 46, 56), with regard to its sample rate, to a sample rate of the third digital filter (44, 54), and wherein the further combiner (36, 46, 56) is configured to combine an output signal from the further interpolator (28, 38, 48) and the output signal of the third digital filter (44, 54).

4. The noise generator (10, 10') in accordance with any of the preceding claims, wherein the first and/or second noise source (32) are/is configured to generate white noise and output same as an output signal.

5. The noise generator (10, 10') in accordance with any of the preceding claims, wherein the ratio is 2:1.

6. The noise generator (10, 10') in accordance with any of the preceding claims, wherein the interpolator (28, 38, 48) is configured to double the output signal of the first filter (24) with regard to its sample rate.

7. The noise generator (10, 10') in accordance with any of the preceding claims, wherein the combiner (36, 46, 56) comprises a summing element.

8. The noise generator (10, 10') in accordance with any of the preceding claims, wherein the first and/or second digital filter (34) comprise/s an FIR filter and/or RRC filter.

9. The noise generator (10, 10') in accordance with any of claims 3 to 8, wherein the second digital filter (34) comprises a filter characteristic in accordance with which the edges comprise a differing steepness.

10. The noise generator (10, 10') in accordance with claim 9, wherein the edge having lower a transition frequency is double as steep as the edge having higher a transition frequency of the second digital filter (34), and/or
wherein the edge having lower a transition frequency is double as steep as an edge having higher a transition frequency of the first digital filter (24).

11. The noise generator (10, 10') in accordance with any of the preceding claims, wherein the first (24) and/or second digital filter (34) are/is coupled to means for level adjustment (25, 29, 35, 39, 45, 49) on the output side.

12. The noise generator (10, 10') in accordance with any of the preceding claims, wherein the noise generator (10, 10') comprises an integrator (14) on the output side, which is configured to sum up the combined output signals over time.

13. The noise generator (10, 10') in accordance with any of the preceding claims, wherein the noise generator (10, 10') comprises means for modulation (16) on the output side, which is configured to transfer the combined output signal from a frequency modulation to a phase modulation.

14. The noise generator (10, 10') in accordance with claim 13, wherein the means for modulation (16) comprise a lookup table which comprises an association of sine/cosine values and phase values over an unlimited or limited range of values.

15. A method for generating a noise signal (12) over a frequency spectrum (f), comprising the steps of:
generating an output signal by means of a first noise source (22) for a first frequency band (f 20) of the frequency spectrum (f) and filtering the output signal of the first noise source (22);
generating an output signal by means of a second noise source (22) for a second higher frequency band (f 30) of the frequency spectrum (f) and filtering the output signal of the second noise source (22), wherein filtering the output signal of the first noise source (22) is performed by means of a first sample rate and filtering the output signal of the second noise source (22) is performed by means of a second sample rate that is larger than the first sample rate, and wherein an edge of the second digital filter (34) which determines a lower frequency band limit is steeper than an edge of the first digital filter (24) which determines an upper frequency band limit; and
adjusting a sample rate of the filtered output signal of the first noise source (22) to a sample rate of the filtered output signal of the second noise source (32) and combining the adjusted output signal of the first noise source (22) and the output signal of the second noise source (22), wherein the ratio between said steepness of the edge of the second digital filter and said edge of the first digital filter depends on the ratio between the second sample rate with respect to the first sample rate.

16. A computer program comprising program code for performing the method in accordance with claim 15, when the program runs on a computer or logic device.

## Revendications

1. Générateur de bruit (10, 10') destiné à générer un signal de bruit sur un spectre de fréquences (f), aux caractéristiques suivantes:
une première source de bruit (22) et un premier filtre numérique (24) pour une première bande de fréquences (f 20) du spectre de fréquences (f), où le premier filtre numérique (24) est conçu pour filtrer le signal de sortie de la première source de bruit (22);
une deuxième source de bruit (32) et un deuxième filtre numérique (34) pour une deuxième bande de fréquences (f 30), à fréquences plus hautes, du spectre de fréquences (f), où le deuxième filtre numérique (34) est conçu pour filtrer le signal de sortie de la deuxième source de bruit (22); et
un interpolateur (28, 38, 48) et un combineur (36, 46, 56),
dans lequel le premier filtre numérique (24) présente une première fréquence de balayage et dans lequel le deuxième filtre numérique (34) présente une deuxième fréquence de balayage qui est supérieure à la première fréquence de balayage,
dans lequel l'interpolateur (28, 38, 48) est conçu pour adapter la fréquence de balayage d'un signal de sortie du premier filtre numérique (24) à une fréquence de balayage du deuxième filtre numérique (34), et dans lequel le combineur (36, 46, 56) est conçu pour combiner le signal de sortie adapté de l'interpolateur (28, 38, 48) et le signal de sortie du deuxième filtre numérique (34),
dans lequel un flanc du deuxième filtre numérique (34), qui détermine une limite de bande de fréquences inférieure, est plus abrupte qu'un flanc du premier filtre numérique (24), qui détermine une limite de bande de fréquences supérieure, dans lequel le rapport entre ladite pente du flanc du deuxième filtre numérique et dudit flanc du premier filtre numérique est fonction du rapport entre la deuxième fréquence de balayage et la première fréquence de balayage.

2. Générateur de bruit (10, 10') selon la revendication 1, dans lequel le flanc du deuxième filtre numérique (34) est deux fois plus abrupte que le flanc du premier filtre numérique (24).

3. Générateur de bruit (10, 10') selon l'une des revendications précédentes, dans lequel le générateur de bruit (10, 10') comporte une troisième source de bruit (42, 52) et un troisième filtre numérique (44, 54) pour une troisième bande de fréquences du spectre de fréquences (f), dans lequel le troisième filtre numérique (44, 54) est conçu pour filtrer le signal de sortie de la troisième source de bruit (42, 52),
dans lequel le troisième filtre numérique (44, 54) présente une troisième fréquence de balayage et dans lequel la fréquence de balayage augmente à une bande de fréquence plus haute, et
dans lequel le générateur de bruit (10, 10') comporte un autre interpolateur (28, 38, 48) et un autre combineur (36, 46, 56), dans lequel l'autre interpolateur (28, 38, 48) est conçu pour adapter un signal de sortie du combineur (36, 46, 56) en ce qui concerne sa fréquence de balayage à une fréquence de balayage du troisième filtre numérique (44, 54), et dans lequel l'autre combineur (36, 46, 56) est conçu pour combiner un signal de sortie de l'autre interpolateur (28, 38, 48) et le signal de sortie du troisième filtre numérique (44, 54).

4. Générateur de bruit (10, 10') selon l'une des revendications précédentes, dans lequel la première et/ou la deuxième source de bruit (32) est conçue pour générer un bruit blanc et le sortir comme signal de sortie.

5. Générateur de bruit (10, 10') selon l'une des revendications précédentes, dans lequel le rapport est de 2:1.

6. Générateur de bruit (10, 10') selon l'une des revendications précédentes, dans lequel l'interpolateur (28, 38, 48) est conçu pour doubler le signal de sortie du premier filtre (24) en ce qui concerne sa fréquence de balayage.

7. Générateur de bruit (10, 10') selon l'une des revendications précédentes, dans lequel le combineur (36, 46, 56) comporte un élément d'addition.

8. Générateur de bruit (10, 10') selon l'une des revendications précédentes, dans lequel le premier et/ou le deuxième filtre numérique (34) comporte un filtre FIR et/ou un filtre RRC.

9. Générateur de bruit (10, 10') selon l'une des revendications 3 à 8, dans lequel le deuxième filtre numérique (34) comporte une caractéristique de filtre selon laquelle les flancs présentent une pente différente.

10. Générateur de bruit (10, 10') selon la revendication 9, dans lequel le flanc à la fréquence de transition plus basse est deux fois plus abrupte que le flanc à la fréquence de transition plus haute du deuxième filtre numérique (34), et/ou
dans lequel le flanc à la fréquence de transition plus basse est deux fois plus abrupte qu'un flanc à une fréquence de transition plus haute du premier filtre numérique (24).

11. Générateur de bruit (10, 10') selon l'une des revendications précédentes, dans lequel le premier (24) et/ou le deuxième filtre numérique (34) est couplé du côté de la sortie à des moyens d'adaptation de niveau (25, 29, 35, 39, 45, 49).

12. Générateur de bruit (10, 10') selon l'une des revendications précédentes, dans lequel le générateur de bruit (10, 10') comporte, du côté de la sortie, un intégrateur (14) qui est conçu pour additionner les signaux de sortie combinés au cours du temps.

13. Générateur de bruit (10, 10') selon l'une des revendications précédentes, dans lequel le générateur de bruit (10, 10') comporte, du côté de la sortie, des moyens de modulation (16) qui sont conçus pour convertir le signal de sortie combiné d'une modulation de fréquence en une modulation de phase.

14. Générateur de bruit (10, 10') selon la revendication 13, dans lequel les moyens de modulation (16) comportent un tableau de consultation qui comporte une attribution de valeurs de sinus/cosinus et de valeurs de phase sur une plage de valeurs illimitée ou limitée.

15. Procédé de génération d'un signal de bruit (12) sur un spectre de fréquences (f), aux étapes suivantes consistant à:
générer un signal de sortie au moyen d'une première source de bruit (22) pour une première bande de fréquences (f 20) du spectre de fréquences (f) et filtrer le signal de sortie de la première source de bruit (22);
générer un signal de sortie au moyen d'une deuxième source de bruit (22) pour une deuxième bande de fréquences (f 30), de fréquences plus hautes, du spectre de fréquences (f) et filtrer le signal de sortie de la deuxième source de bruit (22), où le filtrage du signal de sortie de la première source de bruit (22) a lieu au moyen d'une première fréquence de balayage et le filtrage du signal de sortie de la deuxième source de bruit (22) a lieu à l'aide d'une deuxième fréquence de balayage qui est supérieure à la première fréquence de balayage, et où un flanc du deuxième filtre numérique (34), qui détermine une limite de bande de fréquences inférieure, est plus abrupte qu'un flanc du premier filtre numérique (24) qui détermine une limite de bande de fréquences supérieure; et
adapter une fréquence de balayage du signal de sortie filtré de la première source de bruit (22) à une fréquence de balayage du signal de sortie filtré de la deuxième source de bruit (32) et combiner le signal de sortie adapté de la première source de bruit (22) et le signal de sortie de la deuxième source de bruit (22), où le rapport entre ladite pente du flanc du deuxième filtre numérique et ledit flanc du premier filtre numérique est fonction du rapport entre la deuxième fréquence de balayage et la première fréquence de balayage.

16. Programme d'ordinateur avec un code de programme pour réaliser le procédé selon la revendication 15 lorsque le programme est exécuté sur un ordinateur ou un module logique.
